# EUROPEAN PATENT APPLICATION

(11) **EP 0 614 141 A2**
(43) Date of publication of application: **07.09.1994**
(21) Application number: 94480001.0
(22) Date of filing: 14.01.1994
(51) Int. Cl.: G06F 11/00

(54) **Method and apparatus for improving fault tolerance of multi-media document management systems**

(30) Priority: 01.03.1993 US 24566
(71) Applicant: INTERNATIONAL BUSINESS MACHINES CORPORATION, Armonk, N.Y. 10504 (US)
(72) Inventor: Manthuruthil, George C., Coppell, TX 75019 (US); Reddy, Hari N., Grapevine, TX 76051 (US); Parikh, Shrikant N., Mesquite, TX 75150 (US)
(74) Representative: de Pena, Alain

(57) **Abstract**

Automatic fragmentation of data occurs using the present invention without the intervention of an operator/user. Whenever the amount of data being received by a data processing system is too large to fit onto the currently being used storage device, the data is fragmented and sent to additional storage devices which are associated with the data processing device.

## Description

### Technical Field of The Invention

This invention relates in general to computer software, and in particular to a method and apparatus for improving the fault tolerance of multi-media document management systems.

### Background of The Invention

Modern document management systems are becoming increasingly complex to support sophisticated hierarchically structured documents such as folders and for accommodating the storage and management of an open-ended set of document types including multi-media objects such as audio and video. However, the design of such document management systems has not kept pace with the demands for fault tolerant operation of such systems. Fault tolerance is defined as the ability to cope with failures and/or environmental shortcomings and function as intended, although there may be a still noticeable degradation in performance. Such systems support the storage and management of complex objects which are comprised of multi-media component objects such as image, voice, and video. Typically, each of these objects require storage on the order of several hundred megabytes of space.

Currently, file systems are based on use of a single disk. When the data is being received for storage, it is not generally known how much of the remaining storage space will be needed. Once the space is filled, a disk error will be received. If a programmer/operator is monitoring the system, the programmer will have to select a new storage location for receipt of the remaining data for which there has been no break in the transmission thereof. Thus, even if a programmer is monitoring the system, any data sent subsequent to the filling of the current storage device and prior to the selection of a new storage device will be lost. If no one is monitoring the system, all the data sent subsequent to the filling of the current storage space will be lost. An exception to the loss of all sent data, is the case in which the user program has been written to look for extra space when the current storage location is filled. This addition to a user program requires considerable extra effort to be included and is not typically done.

Consequently, the robustness or reliability (which has taken a more significant role) of such systems has suffered. Therefore, the system becomes unfriendly and not fault tolerant because the burden of handling deficiencies is placed on the user. Thus, there is a need for a method and apparatus which improves the fault tolerance of multi-media document management systems.

### Summary of The Invention

The present invention provides a method and apparatus for improving fault tolerance of a document management system for a data processing device which substantially reduces the amount of additional work required by the prior art. The present invention allows automatic storage of fragments of data too large to fit on a currently used storage device.

In accordance with one aspect of the present invention, a method of improving fault tolerance of a document management system for a data processing device is provided. Data being received by the data processing device is automatically divided into a plurality of fragments whenever a currently being used storage device associated with the data processing device has insufficient space to store all of the data. The fragments are automatically stored on additional predetermined storage devices which are also associated with the data processing device.

In accordance with another aspect of the present invention, a Fragment Table is formed to identify where the plurality of fragments are stored. A Diskspace Availability Table is formed to inform the management system of the additional storage devices available.

### Brief Description of The Drawings

Figure 1 is a schematic illustration of a data processing system in accordance with the present invention;
Figure 2 is a flowchart illustrating the prior art;
Figure 3 is a flowchart illustrating the use of the present invention;
Figure 4 is an illustration of a Diskspace Availability Table in accordance with the present invention;
Figure 5 is an example of a File Fragment Table in accordance with the present invention;
Figure 6 is a flowchart of the operation OPEN in accordance with the present invention;
Figure 7 is a flowchart of the operation READ in accordance with the present invention;
Figure 8 is a flowchart of the operation WRITE in accordance with the present invention; and
Figure 9 is a flowchart of the operation CLOSE in accordance with the present invention.

### Detailed Description of The Invention

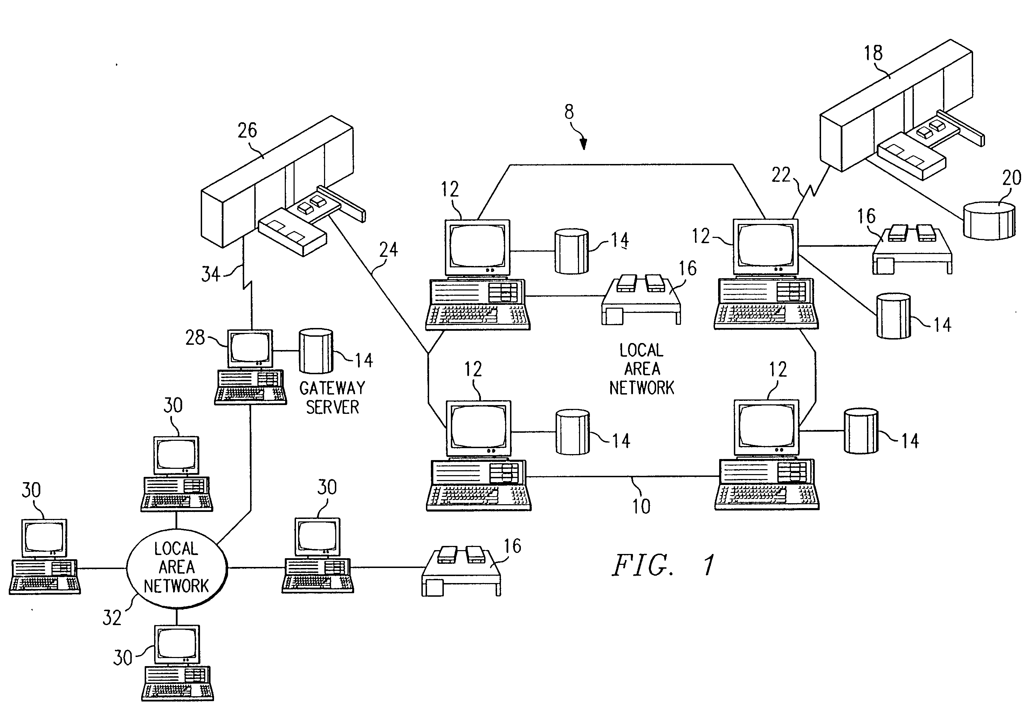

Referring to Figure 1, there is depicted a graphical representation of a data processing system 8, which may be utilized to implement the present invention. As may be seen, data processing system 8 may include a plurality of networks, such as Local Area Networks (LAN) 10 and 32, each of which preferably includes a plurality of individual computers 12 and 30, respectively. Of course, those skilled in the art will appreciate that a plurality of Intelligent Workstations (IWS) coupled to a host processor may be utilized for each such network. As is common in such data processing systems, each individual computer may be coupled to a storage device 14 and/or a printer/output device 16. The data processing system 8 may also include multiple mainframe computers, such as mainframe computer 18, which may be preferably coupled to LAN 10 by means of communications link 22. The mainframe computer 18 may also be coupled to a storage device 20 which may serve as remote storage for LAN 10. Similarly, LAN 10 may be coupled via communications link 24 through a subsystem control unit/communications controller 26 and communications link 34 to a gateway server 28. The gateway server 28 is preferably an individual computer or an intelligent workstation which serves to link LAN 32 to LAN 10.

With respect to LAN 32 and LAN 10, a plurality of documents or resource objects may be stored within storage device 20 and controlled by mainframe computer 18, as resource manager or library service for the resource objects thus stored. Of course, those skilled in the art will appreciate that mainframe computer 18 may be located a great geographic distance from LAN 10 and, similarly, LAN 10 may be located a substantial distance from LAN 32. For example, LAN 32 may be located in California while LAN 10 may be located within Texas and mainframe computer 18 may be located in New York.

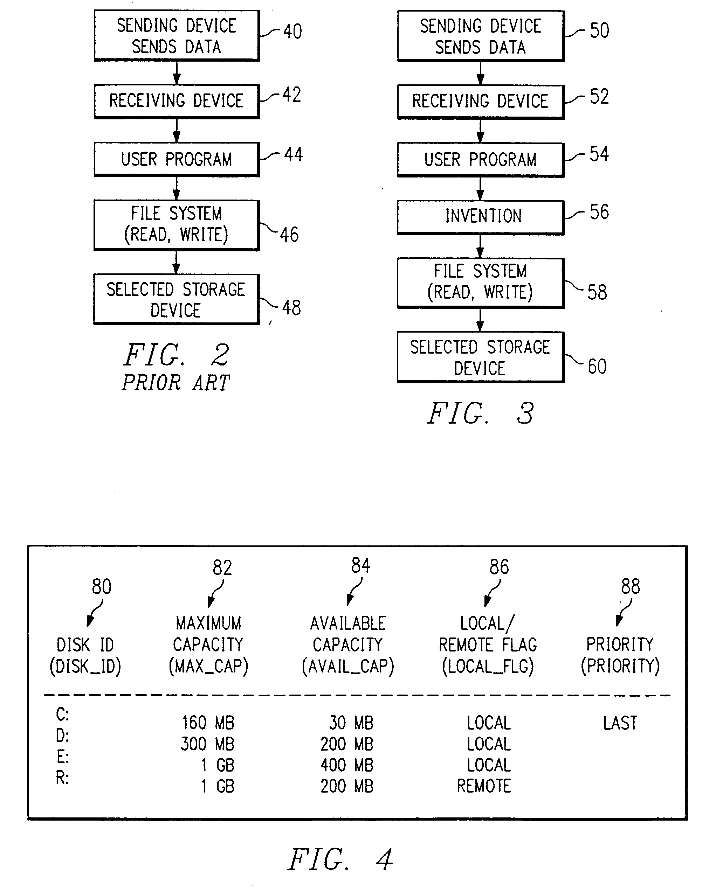

Referring to Figure 2, a flowchart illustrating the receipt and storage of data in accordance with the prior art is illustrated. At block 40, a sending device such as, for example, the mainframe computer 18, the gateway server 28, or one of the individual computers 12 or 30 (see Fig. 1) sends data. At block 42, a receiving device such as, for example, the individual computer 12, receives the data sent at block 40. At block 44, a user program on the receiving device communicates with a file system also on the receiving device at block 46. The file system sends the received data to a selected storage device at block 48. If the selected storage device 48 does not have enough capacity to store all the data sent thereto, an error message will be issued. If the receiving device is not being monitored by an operator/programmer, despite the fact that the sending device will continue to send, the data will not be stored and thus will be lost to the receiving device. If the receiving device is monitored, a programmer or other user will be required to obtain additional storage space. Any data sent during the search for and connection to additional storage space will be lost.

Referring to Figure 3, use of the present invention is illustrated. At block 50, a sending device such as, for example, the mainframe computer 18, the gateway server 28, or one of the individual computers 12 or 30 (see Fig. 1) sends data. At block 52, a receiving device such as, for example, the individual computer 12, receives the data sent at block 50. At block 54, a user program on the receiving device communicates with the present invention also residing on the receiving device in precisely the same way the user program communicates with the file system as described in the description of the prior art in Figure 2. At block 56, the present invention communicates with the file system, local as well as remote, at block 58. The file system in block 58 sends the received data to a selected storage device at block 60. If the selected storage device in block 60 does not have enough capacity to store all the data sent thereto, it notifies the file system in block 58 about the status which, in turn, notifies the present invention in block 56 about a lack of file space. The present invention in block 56 uses a Disk Allocation Table (DAT) to find another storage device where the remaining data can be stored, as will be subsequently described in greater detail. This is done without any programmer/operator intervention. If the present invention can locate an alternate storage device, it proceeds to direct the storage of the remaining data that is received at the receiving device in block 50 to an alternate storage device through commands given by the present invention in block 56.

In implementation of the present invention, it is desirable to provide and maintain information about the various storage devices available such as, for example, capacity and contents. Thus, a Diskspace Availability Table (DAT) and a File Fragment Table (FFT) are provided. Referring first to Figure 4, an example of a DAT is illustrated. A DAT keeps track of the pertinent data about the storage devices that are registered to the system. In column 80, a disk identifier is listed for each storage device that is available to the system in use. Column 82 lists the maximum storage capacity for each storage device listed in column 80, while column 84 lists the remaining storage capacity thereof. Column 86 provides an indication of whether the storage device is located in a local node or on a remote system. Column 88 provides an indication of whether a storage device should be considered in a normal allocation process. For example, it may not be advisable to store application specific data on a "C:" disk (preferable to use for operating system).

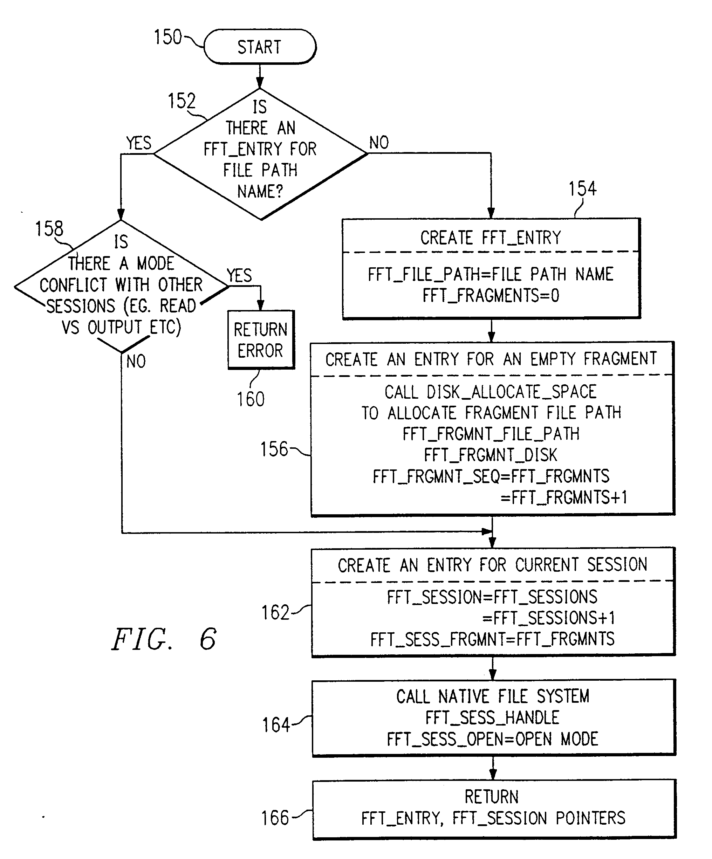

Referring next to Figure 5, an example of an FFT is illustrated. An FFT keeps track of pertinent data about a file that is fragmented and stored on multiple disk systems. A header (not shown) may contain information such as the maximum number of entries in the FFT. Each FFT Entry such as, for example, FFT Entry for file number 1, as indicated by the reference numeral 100, comprises information about all the fragments that together make up that file that is fragmented. For each FFT Entry there is an FFT File Path as indicated by reference numeral 102, an FFT Sessions as indicated by reference numeral 104, and an FFT Fragments as indicated by reference numeral 106. The FFT File Path 102 is the file that needs to be fragmented among multiple disks.

The FFT Sessions 104 indicates a number of active sessions that are opened against the FFT File Path 102. For example, the FFT Sessions 104 has a first FFT Session, as indicated by reference numeral 108, and a second FFT Session, as indicated by reference numeral 110. The FFT Session 108 (as well as the FFT Session 110) includes an FFT Session Sequence 112, an FFT Session Fragment Handle Sequence 114, an FFT Session Open 116, and an FFT Session Handle 118.

The FFT Session Sequence 112 is a session number that will be used in subsequent operations on the particular File Path 102. The FFT Session Fragment Handle Sequence 114 is a sequence number of the fragment of the file in the FFT File Path 102 currently accessed by the FFT Session Sequence 112. The FFT Session Open 116 allows reading or writing to a file. The FFT Session Handle 118 indicates the reference provided by the native file system (whatever file system supports the hardware being used, for example, a file system supported by the local operating system such as OS/2, or a network file system to access remote disks) for a file fragment that is open.

The FFT Fragments 106 indicates a number of fragments that logically represent the content of the FFT File Path 102. The FFT Fragments 106 comprises, for example, FFT Fragment 120 and FFT Fragment 122. FFT Fragment 120 (and similarly 122) comprises an FFT Fragment Sequence 124, an FFT Fragment File Path 126, and an FFT Fragment Disk 128. The FFT Fragment Sequence 124 comprises a unique sequence number assigned to each fragment within the FFT Entry 100. This sequence number is used as a shorthand representation of the fragment during later processing. The FFT Fragment File Path 126 comprises a path name for the fragment. The FFT Fragment Disk 128 indicates the disk system where the fragment is currently stored.

The present invention provides a simple way for applications to manage files that are fragmented across multiple disks (storage locations). To facilitate actual implementation, a series of operations need to be defined which are similar to those supported by the native file system interface provided by an operating system. The following file operations are defined for use with the present invention: 1) OPEN; 2) READ; 3) WRITE; and 4) CLOSE.

Referring to Figure 6, a flowchart illustrates the use of the operation OPEN in accordance with the present invention. The operation Starts at 150 after which it is determined at decision block 152 whether or not there is an FFT Entry for a file path name. If the response to decision block 152 is no, an FFT Entry is created at block 154. Also block 154, the FFT File Path is set equal to the File Path Name, the FFT Fragment Count is set equal to zero, and an FFT Entry Number is set equal to the maximum number of FFT entries plus one. At block 156, an entry is then created for an empty fragment. By referring to the DAT (see Fig. 4) a call to the Disk Allocate Space to allocate a fragment file path occurs.

If the response to decision block 152 is yes, it is determined at decision block 158 whether or not there is a mode conflict with other sessions. The present invention does not grant an OPEN (to Write) request while other sessions are open against the FFT File Path Name, whereas an OPEN (to Read) request is always granted. If the response to decision block 158 is yes, an error is returned at block 160. If the response to decision block 158 is no or subsequent to block 156, an entry is created for the current session at block 162. At block 162, the current session pointer is set to FFT Sessions. The native file system is then called at block 164. The native file system creates a unique FFT FRGMNT file path, as requested, for the current fragment and returns its handle (pointer). At block 166, the present invention returns with pointers to the FFT Entry and the current FFT Session.

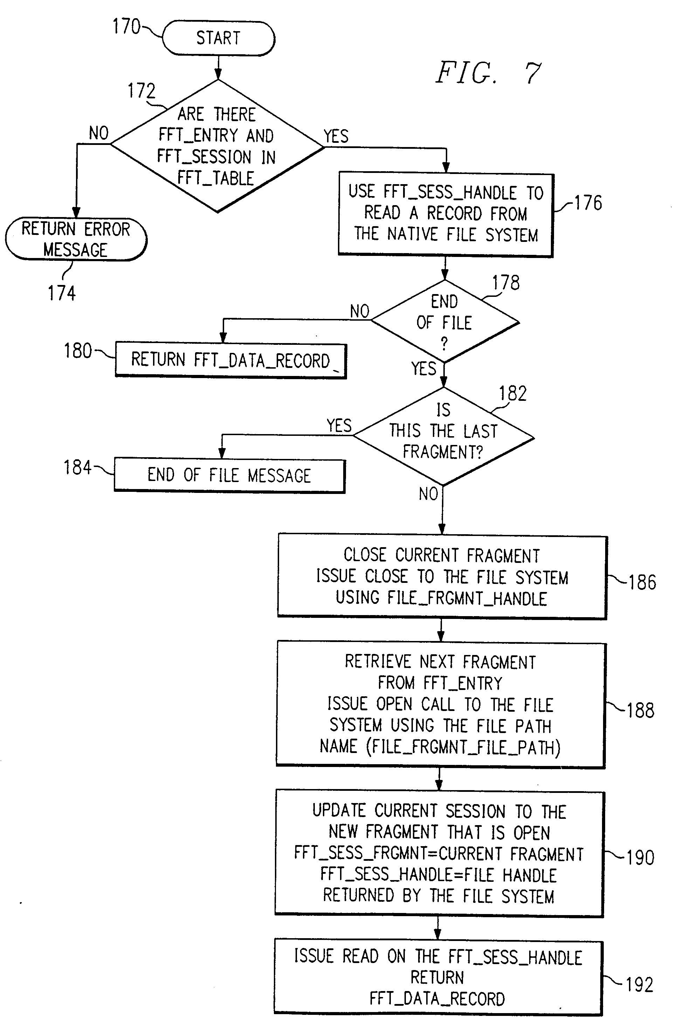

Referring to Figure 7, a flowchart for the operation READ in accordance with the present invention is illustrated. After starting at 170, it is determined at decision block 172 whether or not there is an FFT Entry and an FFT Session in the FFT Table. If the response to decision block 172 is no, an error message is returned at 174. If the response to decision block 172 is yes, the FFT Session Handle is used to read a record from the native file system at block 176. It is then determined at decision block 178 whether or not this is the end of the file. If the response to decision block 178 is no, an FFT Data Record is returned at block 180. If the response to decision block 178 is yes, it is determined at decision block 182 whether or not this is the last fragment. If the response to decision block 182 is yes, an End of File message is returned at block 184. If the response to decision block 182 is no, the current fragment is closed at block 186. The next fragment is retrieved from the FFT Entry as well as issuing an open call to the file system using the File Path Name at block 188. The current session is updated to the new fragment that is opened at block 190. READ is issued on the FFT Session Handle and Return then occurs at block 192.

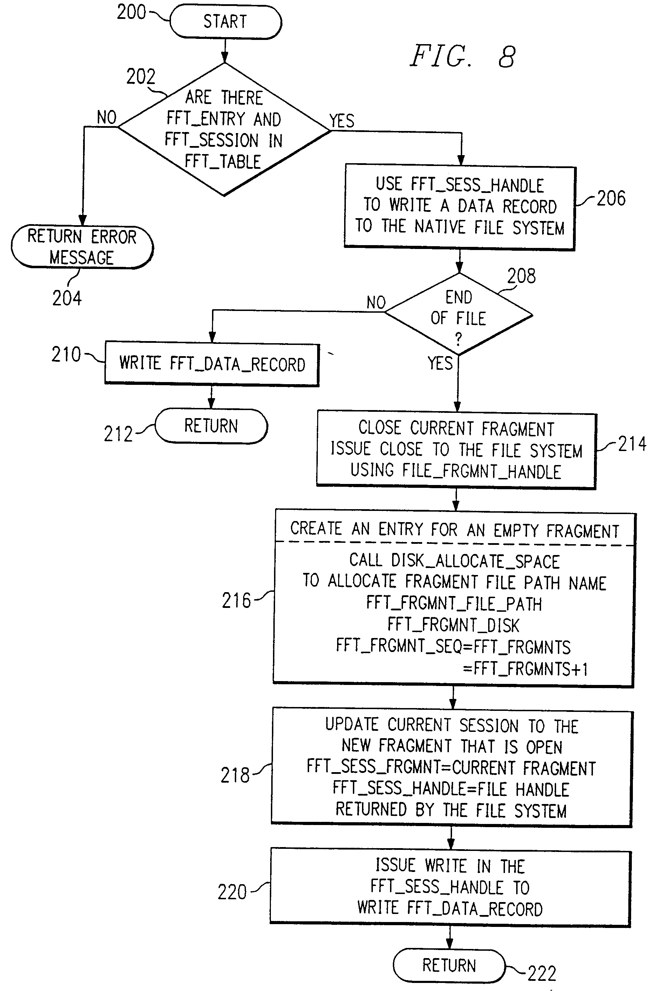

Referring to Figure 8, a flowchart is illustrated for the WRITE operation in accordance with the present invention. After starting at 200, it is determined at decision block 202 whether or not there is an FFT Entry and Session in the FFT Table. If the response to decision block 202 is no, an error message is returned at 204. If the response to decision block 202 is yes, the FFT Session Handle is used to write a data record to the native file system at block 206. It is then determined at decision block 208 whether or not an End of File condition exists. If the response to decision block 208 is no, an FFT Data Record is written at block 210 followed by a return at 212. If the response to decision block 208 is yes, the current fragment is closed by issuing a CLOSE to the file system using the File Fragment Handle at block 214. At block 216, an entry is created for an empty fragment. Call Disk Allocate Space is issued to allocate a Fragment File Path Name by referring to the DAT at block 216. At block 218, the current session is updated to the new fragment that is open. At block 220, a WRITE is issued on the FFT Session Handle to write the FFT Data Record. The present invention then returns at 222.

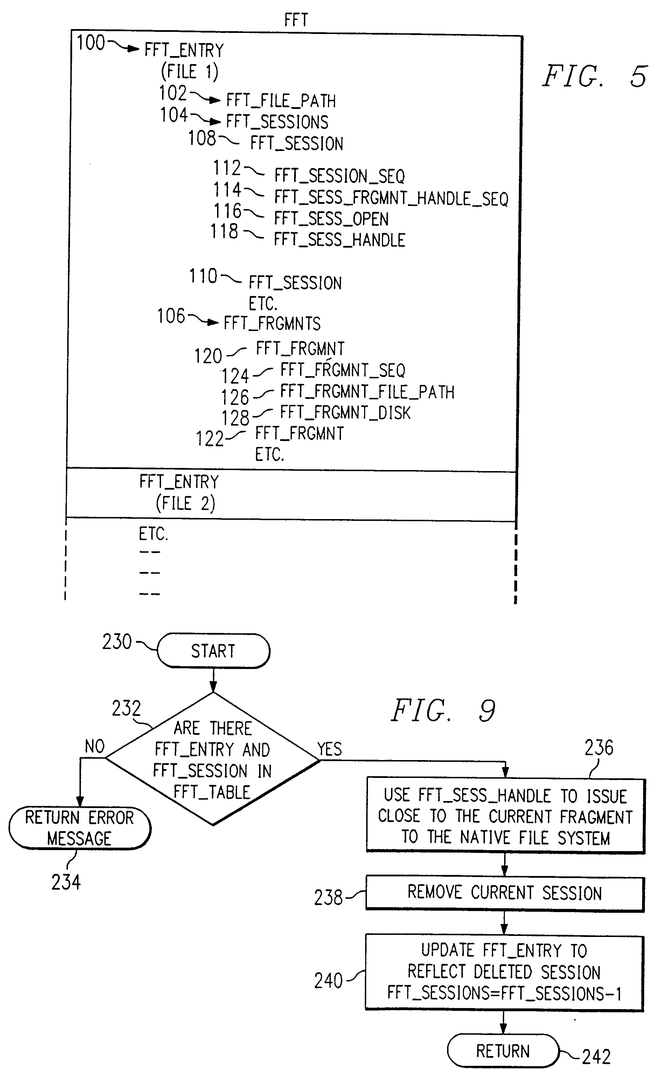

Referring to Figure 9, a flowchart is illustrated for a CLOSE operation in accordance with the present invention. After starting at 230, it is determined at decision block 232 whether or not there is an FFT Entry and an FFT Session in the FFT Table. If the response to decision block 232 is no, an error message is returned at block 234. If the response to decision block 232 is yes, the FFT Session Handle is used to issue a CLOSE to the current fragment to the native file system at block 236. At block 238, the current session is removed. At block 240, the FFT Entry is updated to reflect the deleted session and FFT Sessions is decremented by one. The present invention then returns at 242.

## Claims

1. A method of improving fault tolerance of a document management system for a data processing device, comprising the steps of:
automatically dividing data being received by the data processing device into a plurality of fragments whenever a currently being used storage device associated with the data processing device has insufficient space to store all of said data; and
automatically storing said fragments on additional predetermined storage devices, also associated with the data processing device, as necessary.

2. The method of Claim 1, further comprising the step of:
forming a fragment table to identify where said fragments are stored.

3. The method of Claim 1, further comprising the step of:
forming a diskspace availability table to inform the management system of said additional storage devices.

4. A system for improving fault tolerance of document management of a data processing device, comprising:
means for automatically dividing data being received by the data processing device into a plurality of fragments whenever a currently being used storage device associated with the data processing device has insufficient space to store all of said data; and
means for automatically storing said fragments on additional predetermined storage devices, also associated with the data processing device, as necessary.

5. The system of Claim 4, further comprising:
means for forming a fragment table to identify where said fragments are stored.

6. The system of Claim 4, further comprising:
means for forming a diskspace availability table to inform the management system of said additional storage devices.
